# EUROPEAN PATENT APPLICATION

(11) **EP 4 333 005 A1**
(43) Date of publication of application: **06.03.2024**
(21) Application number: 22793513.7
(22) Date of filing: 15.03.2022
(51) Int. Cl.: H01G 9/07, H01G 4/33, H01G 9/145, H01G 9/15

(54) **DIELECTRIC, CAPACITOR, ELECTRIC CIRCUIT, CIRCUIT BOARD, AND APPARATUS**

(30) Priority: 28.04.2021 JP 2021076877
(71) Applicant: Panasonic Intellectual Property Management Co., Ltd., Kadoma-shi, Osaka 571-0057 (JP)
(72) Inventor: KIKUCHI, Ryosuke, Kadoma-shi, Osaka 571-0057 (JP); KANOU, Manabu, Kadoma-shi, Osaka 571-0057 (JP)
(74) Representative: Eisenführ Speiser
(86) International application number: PCT/JP2022/011753
(87) International publication number: WO 2022/230412

(57) **Abstract**

A dielectric 10 includes a composite oxide. The composite oxide has composition represented by CeₓAl₁₋ₓOₖ and is amorphous. In the composition represented by CeₓAl₁₋ₓOₖ, a requirement 0.400 ≤ x < 0.900 is satisfied. The symbol k is a value for maintaining electroneutrality of the composite oxide.

## Description

### TECHNICAL FIELD

The present invention relates to a dielectric, a capacitor, an electrical circuit, a circuit board, and an apparatus.

### BACKGROUND ART

Capacitors including a metal oxide as a dielectric have been known.

For example, Patent Literature 1 describes, as a common aluminum electrolytic capacitor, a capacitor element including an anode foil including a dielectric oxide film. The dielectric oxide film is formed on a surface of an aluminum foil by anodic oxidation, the surface having an effective surface area expanded by etching.

Patent Literature 1 also describes a foil electrode manufacturing method in which aluminum is etched by applying an alternating current in an electrolyte solution. The electrolyte solution is an aqueous solution containing hydrochloric acid as its main component and at least one of sulfuric acid, oxalic acid, and phosphoric acid. In this manufacturing method, a current density at which the alternating current is applied is its maximum at the beginning of the etching, gradually decreases from the maximum, and becomes 0 in the middle of the etching. Patent Literature 1 describes that according to this manufacturing method, the surface area of a foil electrode can be expanded by formation of minute etch pits at high density, so that the resulting aluminum electrolytic capacitor can have an increased capacitance.

Patent Literature 2 describes a capacitor including a dielectric layer positioned on a porous portion of an electrically conductive porous substrate. Patent Literature 2 describes metal oxides such as Al₂O₃ as the material of the dielectric layer. The dielectric layer is not an anodic film, and is formed by deposition such as atomic layer deposition.

### CITATION LIST

### Patent Literature

Patent Literature 1: JP 2005-203529 A
Patent Literature 2: WO 2017/026247 A1

### SUMMARY OF INVENTION

### Technical Problem

The techniques described in Patent Literatures 1 and 2 leave room for reexamination from the viewpoint of maintaining the dielectric loss of the capacitor low and increasing the capacitance thereof. Therefore, the present disclosure provides a dielectric advantageous in maintaining the dielectric loss of a capacitor low and increasing the capacitance thereof.

### Solution to Problem

The present disclosure provides a dielectric including a composite oxide having composition represented by CeₓAl₁₋ₓOₖ, the composite oxide being amorphous, wherein
in the composition, a requirement 0.400 ≤ x < 0.900 is satisfied, and k is a value for maintaining electroneutrality of the composite oxide.

### Advantageous Effects of Invention

The present disclosure provides a dielectric advantageous in maintaining the dielectric loss of a capacitor low and increasing the capacitance thereof.

### BRIEF DESCRIPTION OF DRAWINGS

FIG. 1 is a cross-sectional view of a capacitor according to an embodiment of the present disclosure.
FIG. 2A is a cross-sectional view of a capacitor according to another embodiment of the present disclosure.
FIG. 2B is a cross-sectional view of a variant of the capacitor shown in FIG. 2A.
FIG. 3A schematically shows an electrical circuit according to an embodiment of the present disclosure.
FIG. 3B schematically shows a circuit board according to an embodiment of the present disclosure.
FIG. 3C schematically shows an apparatus according to an embodiment of the present disclosure.
FIG. 4 is a graph showing a relation between a dielectric constant of a dielectric film of each sample and a ratio between the numbers of metal atoms.
FIG. 5 is a graph showing a relation between a dielectric loss tangent of a dielectric film of each sample and a ratio between the numbers of metal atoms.
FIG. 6 shows X-ray diffraction (XRD) patterns of dielectric films according to Samples 1 to 4.
FIG. 7 shows XRD patterns of dielectric films according to Samples 5 and 6.
FIG. 8 shows XRD patterns of dielectric films according to Samples 7 to 11.

### DESCRIPTION OF EMBODIMENTS

### (Findings on which the present disclosure is based)

A porous portion can be formed by etching of a surface of a metallic foil. A capacitor including a metal oxide as a dielectric can be produced by subjecting a metallic foil having a porous portion to a conversion treatment, such as anodic oxidation, to form a metal oxide over a surface of a metal framework of the porous portion. The porous portion having a large surface area allows the capacitor to have a high capacitance. However, the surface area of the porous portion cannot be expanded without limitation. Moreover, in some applications of capacitors, it may be difficult to use the metallic foil having the porous portion as electrodes of the capacitors. It is also important to maintain dielectric losses of capacitors low.

In view of these circumstances, the present inventors made intensive studies to create a new dielectric having properties advantageous in maintaining the dielectric loss of a capacitor low and increasing the capacitance thereof. Through a lot of trial and error, the present inventors have newly found that a material including a given composite oxide including Ce and Al is advantageous in maintaining the dielectric loss of a capacitor low and increasing the capacitance thereof. The present inventors have consequently invented a dielectric and a capacitor of the present disclosure.

### (Summary of one aspect according to the present disclosure)

A dielectric according to a first aspect of the present disclosure includes a composite oxide having composition represented by CeₓAl₁₋ₓOₖ, the composite oxide being amorphous, wherein
in the composition, a requirement 0.400 ≤ x < 0.900 is satisfied, and k is a value for maintaining electroneutrality of the composite oxide.

The dielectric according to the first aspect is likely to have a high dielectric constant and a low dielectric loss tangent and is advantageous in maintaining the dielectric loss of a capacitor low and increasing the capacitance thereof.

According to a second aspect of the present disclosure, for example, the dielectric according to the first aspect may include a sputtered film. According to the second aspect, a dielectric film for capacitors can be formed by sputtering.

According to a third aspect of the present disclosure, for example, the dielectric according to the first or second aspect may be for a capacitor. According to the third aspect, the dielectric can be included in capacitors.

A capacitor according to a fourth aspect of the present disclosure includes:
a first electrode;
the dielectric according to any one of the first to third aspects disposed on the first electrode; and
a second electrode covering at least a portion of the dielectric.

According to the fourth aspect, the dielectric is likely to have a high dielectric constant and a low dielectric loss tangent. Consequently, the capacitance of the capacitor is likely to be increased and the dielectric loss of the capacitor is likely to be maintained low.

According to a fifth aspect of the present disclosure, for example, in the capacitor according to the fourth aspect, at least a portion of the first electrode may be a porous portion. According to the fifth aspect, the surface area of the first electrode is likely to be large, and the capacitance of the capacitor is likely to be increased.

According to a sixth aspect of the present disclosure, for example, in the capacitor according to the fourth or fifth aspect, the first electrode may include a valve metal. According to the sixth aspect, a member including a valve metal can be used as the first electrode.

According to a seventh aspect of the present disclosure, for example, in the capacitor according to the sixth aspect, the valve metal may include at least one selected from the group consisting of aluminum, tantalum, and niobium. According to the seventh aspect, a member including any of the above valve metals can be used as the first electrode.

According to an eighth aspect of the present disclosure, for example, in the capacitor according to any one of the fourth to seventh aspects, the second electrode may include at least one selected from the group consisting of aluminum, tantalum, niobium, gold, silver, platinum, and nickel. According to the eighth aspect, a member including any of the above metals can be used as the second electrode.

According to a ninth aspect of the present disclosure, for example, the capacitor according to the fifth aspect may further include an electrolyte in contact with the second electrode. Additionally, the electrolyte may fill the porous portion and may include at least one selected from the group consisting of an electrolyte solution, an electrically conductive polymer, and manganese oxide. According to the ninth aspect, a capacitor including an electrolyte such as an electrolyte solution can be provided.

An electrical circuit according to a tenth aspect of the present disclosure includes the capacitor according to any one of the fourth to ninth aspects. According to the tenth aspect, the capacitor is likely to have a low dielectric loss and a high capacitance, and thus the electrical circuit is likely to have improved properties.

A circuit board according to an eleventh aspect of the present disclosure includes the capacitor according to any one of the fourth to ninth aspects. According to the eleventh aspect, the capacitor is likely to have a low dielectric loss and a high capacitance, and thus the circuit board is likely to have improved properties.

An apparatus according to a twelfth aspect of the present disclosure includes the capacitor according to any one of the fourth to ninth aspects. According to the twelfth aspect, the capacitor is likely to have a low dielectric loss and a high capacitance, and thus the apparatus is likely to have improved properties.

### (Embodiments)

Embodiments of the present disclosure will be described hereinafter with reference to the drawings. The present disclosure is not limited to the following embodiments.

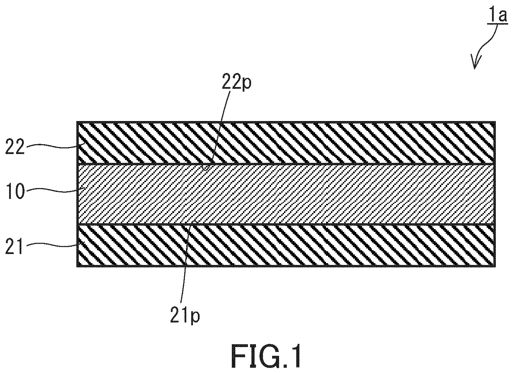

FIG. 1 is a cross-sectional view of a capacitor 1a according to an example of an embodiment of the present disclosure. As shown in FIG. 1, the capacitor 1a includes a dielectric 10. In other words, the dielectric 10 is a material for a capacitor. The dielectric 10 includes a composite oxide having composition represented by CeₓAl₁₋ₓOₖ. A requirement 0.400 ≤ x < 0.900 is satisfied in this composition. Additionally, k is a value for maintaining electroneutrality of the composite oxide. In the composite oxide, when the valence of Ce is trivalent, k is 1.5. In the composite oxide, when the valence of Ce is tetravalent, k is 1.7 or more and less than 1.95. The composite oxide is amorphous. The dielectric 10 including such a composite oxide is likely to have a high dielectric constant and a low dielectric loss tangent. Consequently, the capacitor 1a is likely to exhibit a high capacitance and maintain a dielectric loss low.

The composite oxide included in the dielectric 10 is, for example, a solid solution of aluminum oxide and cerium oxide.

The value x is desirably 0.475 or more. In such cases, the dielectric 10 is likely to have a higher dielectric constant. The value x may be, in some cases, 0.500 or more, or 0.600 or more.

The value of x is desirably 0.880 or less, more desirably 0.850 or less, even more desirably 0.840 or less, and particularly desirably 0.830 or less. In such cases, the dielectric 10 is likely to have a low dielectric loss tangent.

The dielectric constant of the dielectric 10 is not limited to a particular value.

The dielectric constant of the dielectric 10 is, for example, higher than that of Al₂O₃. The dielectric constant of the dielectric 10 at 10 kHz is, for example, 14.0 or more, desirably 15.0 or more, more desirably 18.0 or more. The dielectric constant of the dielectric 10 at 10 kHz may be, in some cases, 22.0 or more, or 25.0 or more. The dielectric constant of the dielectric 10 at 1 MHz is, for example, 13.0 or more, desirably 14.0 or more, more desirably 15.0 or more, even more desirably 17.0 or more. The dielectric constant of the dielectric 10 at 1 MHz may be, in some cases, 21.0 or more, or 24.0 or more.

The dielectric loss tangent of the dielectric 10 is not limited to a particular value.

The dielectric loss tangents of the dielectric 10 at 10 kHz and 1 MHz are each, for example, 0.020 or less. The dielectric loss tangents of the dielectric 10 at 10 kHz and 1 MHz may be, for example, less than 0.020.

As described above, the composite oxide is amorphous. Since the dielectric 10 includes such a composite oxide, occurrence of a leak current in the dielectric 10 is less likely. The reason is presumably because occurrence of a leak current attributable to a grain boundary can be reduced in the composite oxide. As a result, the dielectric 10 is likely to have a high dielectric constant and a low dielectric loss tangent. For example, when a peak whose full width at half maximum is 5° or less and which is distinct from a background is not confirmed in an XRD pattern of the composite oxide at diffraction angles of 10° to 50°, the compound included in the dielectric 10 is concluded to be amorphous.

As shown in FIG. 1, the dielectric 10 of the capacitor 1a includes, for example, a film. The dielectric 10 includes, for example, a sputtered film. In this case, the dielectric 10 is likely to have a high dielectric constant and a low dielectric loss tangent. Additionally, in this case, a composition ratio between the metal atoms in the composite oxide is easily controlled to be a desired value. The dielectric 10 may be an anodic film or another thin film. The method for forming the other thin film is, for example, vacuum deposition, pulsed laser deposition (PLD), atomic layer deposition (ALD), and chemical vapor deposition (CVD).

As shown in FIG. 1, the capacitor 1a further includes a first electrode 21 and a second electrode 22. The dielectric 10 is disposed on the first electrode 21. The second electrode 22 covers at least a portion of the dielectric 10.

The materials of the first electrode 21 and the second electrode 22 are not limited to particular materials. The first electrode 21 and the second electrode 22 include, for example, a metal. For example, the first electrode 21 is desirably formed of an electrically conductive metal. The first electrode 21 includes, for example, a valve metal. Examples of the valve metal include aluminum, tantalum, and niobium. The first electrode 21 includes, for example, at least one selected from the group consisting of aluminum, tantalum, and niobium as the valve metal. The first electrode 21 may include a noble metal such as gold or platinum, or may include nickel.

The second electrode 22 is desirably, for example, an electrically conductive metal. The second electrode 22 may include, for example, a valve metal such as aluminum, tantalum, or niobium, may include a noble metal such as gold, silver, or platinum, or may include nickel. The second electrode 22 includes, for example, at least one selected from the group consisting of aluminum, tantalum, niobium, gold, silver, platinum, and nickel.

As shown in FIG. 1, the first electrode 21 has a principal surface 21p. The term "principal surface" of an electrode refers to a surface thereof having the largest area. One principal surface of the dielectric 10 is, for example, in contact with the principal surface 21p. The second electrode 22 has a principal surface 22p parallel to the principal surface 21p. The other principal surface of the dielectric 10 is, for example, in contact with the principal surface 22p.

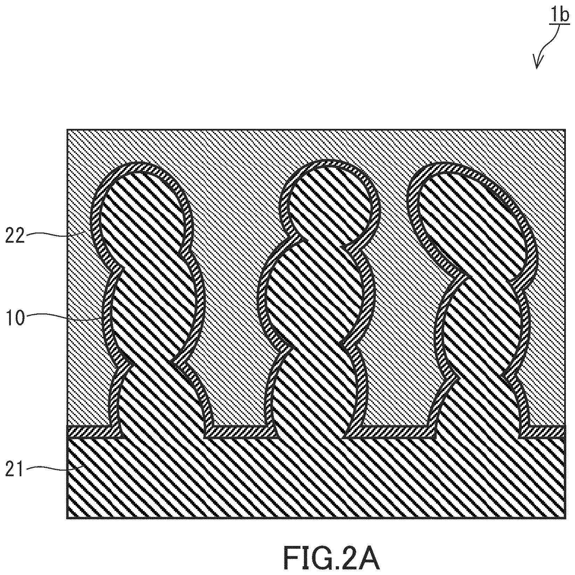

FIG. 2A is a cross-sectional view showing a capacitor 1b according to another example of the embodiment of the present disclosure. The capacitor 1b is configured in the same manner as the capacitor 1a unless otherwise described. The components of the capacitor 1b that are the same as or correspond to the components of the capacitor 1a are denoted by the same reference characters, and detailed descriptions of such components are omitted. The description given for the capacitor 1a is applicable to the capacitor 1b unless there is a technical inconsistency.

As shown in FIG. 2A, at least a portion of the first electrode 21 is a porous portion in the capacitor 1b. This structural feature is likely to increase the surface area of the first electrode 21 and the capacitance of the capacitor. The porous structure can be formed, for example, by etching of a metallic foil, heat treatment of powder, or the like.

As shown in FIG. 2A, for example, the film of the dielectric 10 is arranged on a surface of the porous portion of the first electrode 21. In this case, anodization or ALD can be adopted as the method for forming the film of the dielectric 10.

In the capacitor 1b, the second electrode 22 is disposed, for example, to fill a space around the porous portion of the first electrode 21.

The second electrode 22 may include, for example, a valve metal such as aluminum, tantalum, or niobium, may include a noble metal such as gold, silver, or platinum, or may include nickel. The second electrode 22 includes, for example, at least one selected from the group consisting of aluminum, tantalum, niobium, gold, silver, platinum, and nickel.

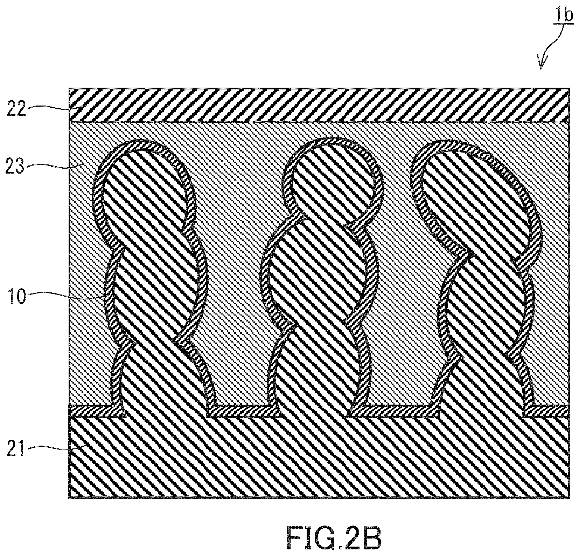

The capacitors 1a and 1b may be electrolytic capacitors. In this case, for example, an electrolyte 23 is disposed between the first electrode 21 and the second electrode 22. The electrolyte 23 may be disposed between the dielectric 10 and the second electrode 22. FIG. 2B shows a variant of the capacitor 1b configured as an electrolytic capacitor. In the capacitor 1b, the electrolyte 23 is disposed, for example, to fill the space around the porous portion of the first electrode 21.

The electrolyte includes, for example, at least one selected from the group consisting of an electrolyte solution and an electrically conductive polymer. Examples of the electrically conductive polymer include polypyrrole, polythiophene, polyaniline, and derivatives of these. The electrolyte may be made of a manganese compound such as manganese oxide. The electrolyte may include a solid electrolyte.

The electrolyte including the electrically conductive polymer can be formed by performing chemical polymerization, electrolytic polymerization, or both chemical polymerization and electrolytic polymerization of a monomer as a raw material on the dielectric 10. The electrolyte including the electrically conductive polymer may be formed by adhering a solution or dispersion of the electrically conductive polymer onto the dielectric 10.

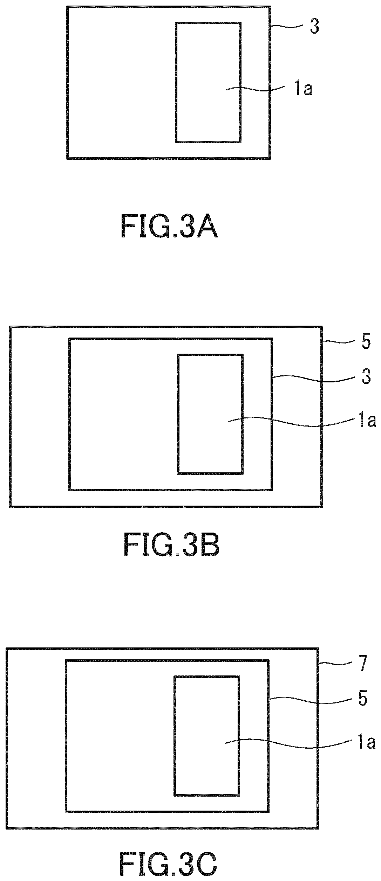

FIG. 3A schematically shows an electrical circuit 3 according to the embodiment of the present disclosure. As shown in FIG. 3A, the electrical circuit 3 includes the capacitor 1a. The electrical circuit 3 is not limited to a particular circuit as long as the electrical circuit 3 includes the capacitor 1a. The electrical circuit 3 may be an active circuit or a passive circuit. The electrical circuit 3 may be a discharging circuit, a smoothing circuit, a decoupling circuit, or a coupling circuit. Since the electrical circuit 3 includes the capacitor 1a, the electrical circuit 3 is likely to have desired properties. For example, it is likely that the capacitor 1a reduces noise in the electrical circuit 3. The electrical circuit 3 may include the capacitor 1b instead of the capacitor 1a.

FIG. 3B schematically shows a circuit board 5 according to the embodiment of the present disclosure. As shown in FIG. 3B, the circuit board 5 includes the capacitor 1a. The circuit board 5 is not limited to a particular circuit board as long as the circuit board 5 includes the capacitor 1a. The circuit board 5 includes, for example, the electrical circuit 3. The circuit board 5 may be an embedded board or a motherboard. The circuit board 5 may include the capacitor 1b instead of the capacitor 1a.

FIG. 3C schematically shows an apparatus 7 according to the embodiment of the present disclosure. As shown in FIG. 3C, the apparatus 7 includes the capacitor 1a. The apparatus 7 is not limited to a particular apparatus as long as the apparatus 7 includes the capacitor 1a. The apparatus 7 includes, for example, the circuit board 5. The apparatus 7 may be an electronic device, a communication device, a signalprocessing device, or a power-supply device. The apparatus 7 may be a server, an AC adapter, an accelerator, or a flat-panel display such as a liquid crystal display (LCD). The apparatus 7 may be a USB charger, a solid-state drive (SSD), an information terminal such as a PC, a smartphone, or a tablet PC, or an Ethernet switch.

### EXAMPLES

Hereinafter, the present disclosure will be described in more detail with reference to examples. The examples given below are just examples, and the present disclosure is not limited to them.

### (Production of sample)

Sputtering was performed using Ti and Pt as targets to form a lower electrode being a laminate of a thin Ti film and a thin Pt film on a substrate. The thin Ti film was in contact with the substrate. An alkali-free glass EAGLE XG manufactured by Corning Incorporated was used as the substrate. During the sputtering, an environment of the substrate was maintained at a pressure of 0.3 Pa, and an argon gas occupied the entire volume of the environment. Additionally, the temperature of the substrate was adjusted at 600°C.

Next, a dielectric film of each sample was formed on the lower electrode by co-sputtering using Al₂O₃ and CeO₂ as targets. Co-sputtering conditions were adjusted so that the dielectric film would have a thickness of 100 nm. During the co-sputtering, an environment of the substrate was maintained at a pressure of 0.3 Pa, and an argon gas and an oxygen gas respectively occupied 90% and 10% of the volume of the environment. Additionally, the substrate was not heated. A composition ratio between Al and Ce in each sample was controlled by adjusting a film formation time by opening and closing a shutter. Dielectric films according to Samples 1 to 9 were obtained in this manner. Next, sputtering was performed using Pt as a target to form an upper electrode made of Pt and having a diameter of 104 µm and a thickness of 100 nm on each dielectric film. Samples 1 to 9 were obtained in this manner.

### (Identification of composition)

Before the formation of the upper electrode, the dielectric film according to each sample was subjected to fluorescent X-ray analysis using a fluorescent X-ray analyzer ZSX Primus IV manufactured by Rigaku Corporation, and quantitative analysis of elements in the dielectric film according to each sample was performed. The fundamental parameter method (FP method) was adopted as the quantitative analysis method. A ratio Ce/(Al+Ce) of the number of Ce atoms to the number of Al and Ce atoms in the dielectric film according to each sample was determined from the results of the quantitative analysis. Table 1 shows the results.

### (Confirmation for crystal phase)

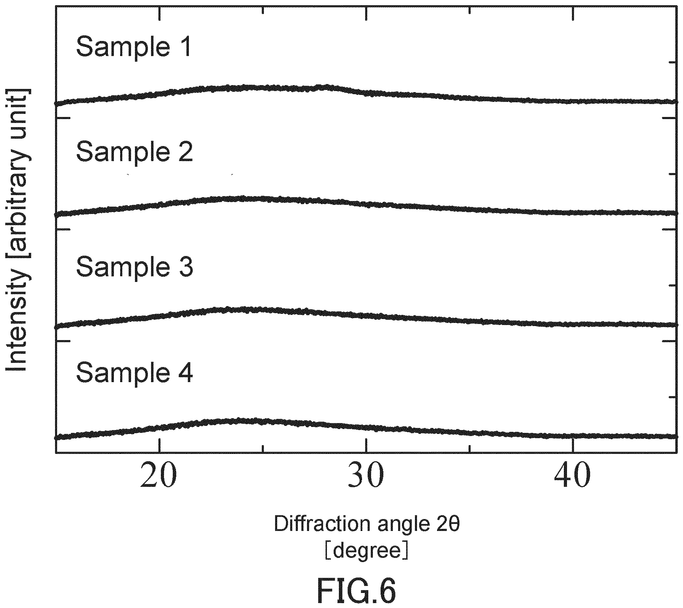

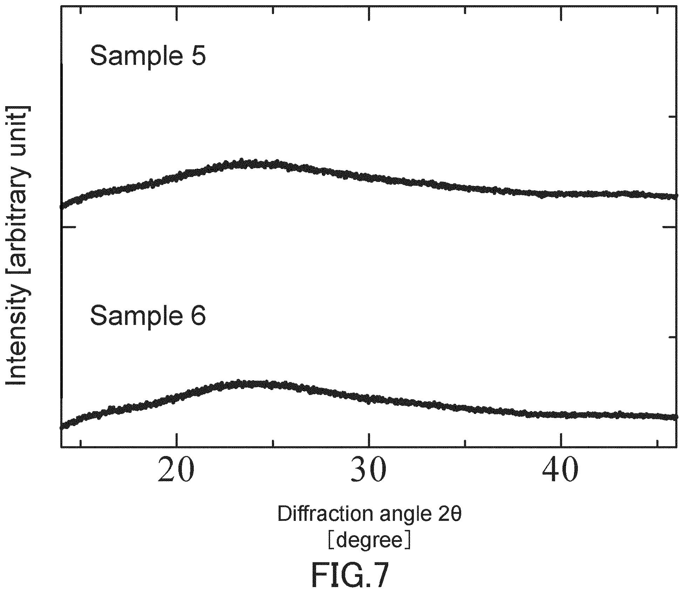

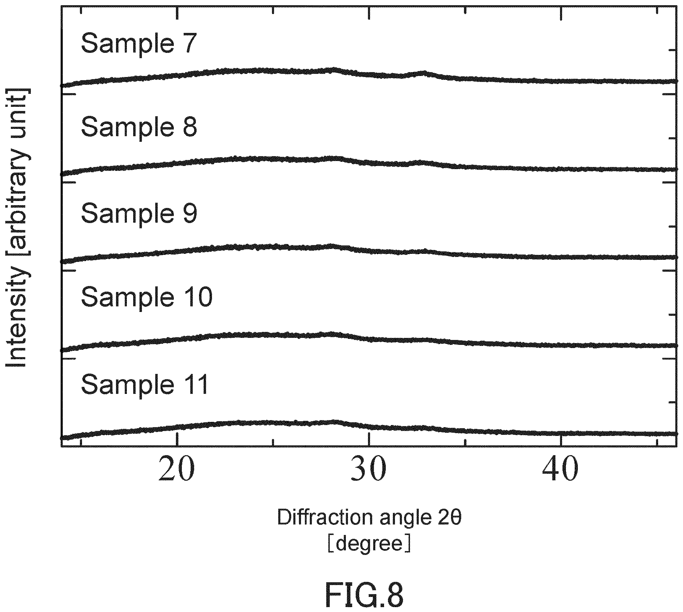

Before the formation of the upper electrode, the dielectric film according to each sample was subjected to X-ray diffraction measurement using an X-ray diffractometer D8 Discover manufactured by Bruker Corporation to obtain an XRD pattern of each dielectric film by 2θ/θ scan. FIG. 6 shows XRD patterns of the dielectric films according to Samples 1 to 4. FIG. 7 shows XRD patterns of the dielectric films according to Samples 5 and 6. FIG. 8 shows XRD patterns of the dielectric films according to Samples 7 to 11. In FIGS. 6, 7, and 8, the vertical axis represents a diffraction intensity in arbitrary unit, while the horizontal axis represents a diffraction angle. In FIGS. 6, 7, and 8, there are tick marks between the XRD patterns adjacent along the vertical axis, the tick marks indicating that the diffraction intensity is 0 at the marks. In the measurement, a Cu-Kα ray was used as an X-ray source, and the voltage and the current were adjusted at 50 kV and 100 mA, respectively. The measurement was performed using a two-dimensional detector, and conversion into 2θ was performed.

### (Dielectric properties)

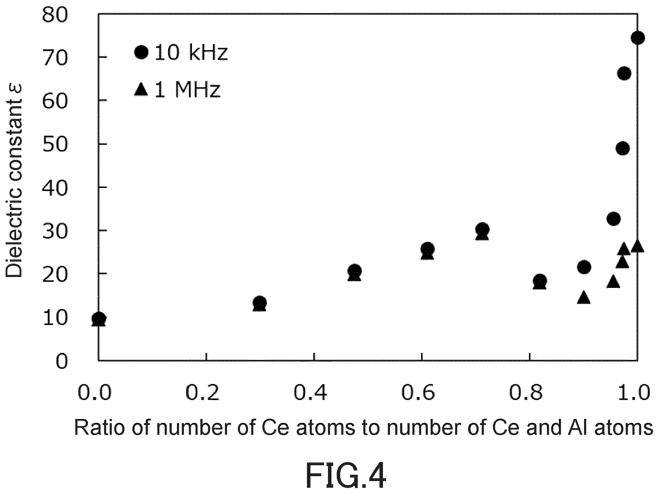

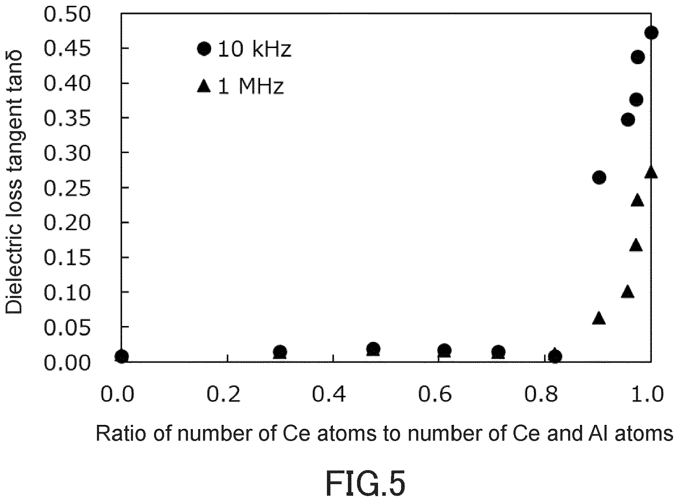

A dielectric constant ε and a dielectric loss tangent tanδ of the dielectric film according to each sample were measured at 10 kHz and 1 MHz using an LCR meter. After measuring a capacitance of each sample, the dielectric constant was determined on the basis of the measurement value of the capacitance, the thickness of the dielectric film, and the areas of the electrodes. An ambient temperature was 25°C in the measurement. Table 1 shows the results. FIG. 4 shows a relation between the dielectric constant of each dielectric film and the ratio of the number of Ce atoms to the number of Al and Ce atoms. In FIG. 4, the vertical axis represents the dielectric constant of each dielectric film, while the horizontal axis represents the ratio of the number of Ce atoms to the number of Al and Ce atoms. FIG. 5 shows a relation between the dielectric loss tangent of each dielectric film and the ratio of the number of Ce atoms to the number of Al and Ce atoms. In FIG. 5, the vertical axis represents the dielectric loss tangent of each dielectric film, while the horizontal axis represents the ratio of the number of Ce atoms to the number of Al and Ce atoms.

As shown in Table 1 and FIG. 4, the dielectric constants of the dielectric films according to Samples 1 to 4, in which the ratio Ce/(Al+Ce) between the numbers of atoms is 0.400 or more and less than 0.900, at frequencies of 10 kHz and 1 MHz are more than 15.0. Moreover, according to Table 1 and FIG. 5, the dielectric loss tangents of the dielectric films according to Samples 1 to 4 at frequencies of 10 kHz and 1 MHz are very low, namely, less than 0.020. It is indicated that the dielectric including the composite oxide which includes Al and Ce and in which the ratio Ce/(Al+Ce) between the numbers of atoms is controlled to 0.400 or more and less than 0.900 satisfies both a high dielectric constant and a low dielectric loss tangent.

FIG. 6 shows X-ray diffraction (XRD) patterns of the dielectric films according to Samples 1 to 4. From the fact that a peak whose full width at half maximum is 5° or less and which is distinct from a background is not confirmed in the XRD patterns of the dielectric films according to Samples 1 to 4 shown in FIG. 6, it can be concluded that the compound included in each dielectric film is amorphous. It is indicated that the dielectric satisfies both a high dielectric constant and a low dielectric loss tangent because the dielectric including the above composite oxide is amorphous.

As shown in Table 1 and FIG. 4, the dielectric constants of the dielectric films according to Samples 5 and 6, in which the ratio Ce/(Al+Ce) between the numbers of atoms is less than 0.300, at frequencies of 10 kHz and 1 MHz are less than 15. On the other hand, as shown in Table 1 and FIG. 5, it is understood that the dielectric loss tangents of the dielectric films according to Samples 5 and 6 at frequencies of 10 kHz and 1 MHz are very low, namely, less than 0.020. From these facts, it is understood that the dielectric including the composite oxide in which the ratio Ce/(Al+Ce) between the numbers of atoms is controlled to less than 0.300 cannot be said to satisfy both a high dielectric constant and a low dielectric loss tangent. From the fact that a peak whose full width at half maximum is 5° or less and which is distinct from a background is not confirmed in the XRD patterns of the dielectric films according to Samples 5 and 6 shown in FIG. 7, it can be concluded that the compound included in each dielectric film is amorphous.

As shown in Table 1 and FIG. 4, the dielectric constants of the dielectric films according to Samples 7 to 11, in which the ratio Ce/(Al+Ce) between the numbers of atoms is 0.900 or more, at frequencies of 10 kHz and 1 MHz are high, namely, 14 or more. On the other hand, as shown in Table 1 and FIG. 5, the dielectric loss tangents of the dielectric films according to Samples 7 to 11 at frequencies of 10 kHz and 1 MHz are high, namely, 0.1 or more. From these facts, it is understood that the dielectric including the composite oxide in which the ratio Ce/(Al+Ce) between the numbers of atoms is controlled to 0.900 or more cannot be said to satisfy both a high dielectric constant and a low dielectric loss tangent. From the fact that a peak whose full width at half maximum is 5° or less and which is distinct from a background is not confirmed in the XRD patterns of the dielectric films according to Samples 7 to 11 shown in FIG. 8, it can be concluded that the compound included in each dielectric film is amorphous.

**[Table 1]**

| | Ratio between numbers of atoms | 10 kHz | | 1 MHz | | Crystal phase |
|---|---|---|---|---|---|---|
| | | Dielectric constant | Dielectric loss tangent | Dielectric constant | Dielectric loss tangent | |
| | Ce/(Al+Ce) | ε | tanδ | ε | tanδ | |
| Sample 1 | 0.818 | 18.5 | 0.009 | 17.9 | 0.012 | Amorphous |
| Sample 2 | 0.712 | 30.4 | 0.015 | 29.4 | 0.015 | Amorphous |
| Sample 3 | 0.610 | 25.8 | 0.017 | 24.8 | 0.017 | Amorphous |
| Sample 4 | 0.475 | 20.8 | 0.019 | 19.8 | 0.018 | Amorphous |
| Sample 5 | 0.299 | 13.5 | 0.015 | 12.9 | 0.014 | Amorphous |
| Sample 6 | 0.000 | 9.8 | 0.009 | 9.4 | 0.011 | Amorphous |
| Sample 7 | 1000 | 74.6 | 0.473 | 26.5 | 0.273 | Amorphous |
| Sample 8 | 0.975 | 66.3 | 0.438 | 25.9 | 0.233 | Amorphous |
| Sample 9 | 0.971 | 49.0 | 0.377 | 22.8 | 0.168 | Amorphous |
| Sample 10 | 0.955 | 32.8 | 0.348 | 18.3 | 0.102 | Amorphous |
| Sample 11 | 0.900 | 21.6 | 0.265 | 14.6 | 0.063 | Amorphous |

### INDUSTRIAL APPLICABILITY

The dielectric of the present disclosure can be suitably included in electronic components such as electrolytic capacitors.

## Claims

1. A dielectric comprising a composite oxide having composition represented by CeₓAl₁₋ₓOₖ, the composite oxide being amorphous, wherein
in the composition, a requirement 0.400 ≤ x < 0.900 is satisfied, and k is a value for maintaining electroneutrality of the composite oxide.

2. The dielectric according to claim 1, wherein the dielectric includes a sputtered film.

3. The dielectric according to claim 1 or 2, wherein the dielectric is for a capacitor.

4. A capacitor comprising:
a first electrode;
the dielectric according to any one of claims 1 to 3 disposed on the first electrode; and
a second electrode covering at least a portion of the dielectric.

5. The capacitor according to claim 4, wherein at least a portion of the first electrode is a porous portion.

6. The capacitor according to claim 4 or 5, wherein the first electrode includes a valve metal.

7. The capacitor according to claim 6, wherein the valve metal includes at least one selected from the group consisting of aluminum, tantalum, and niobium.

8. The capacitor according to any one of claims 4 to 7, wherein the second electrode includes at least one selected from the group consisting of aluminum, tantalum, niobium, gold, silver, platinum, and nickel.

9. The capacitor according to claim 5, further comprising an electrolyte in contact with the second electrode, wherein
the electrolyte fills the porous portion and includes at least one selected from the group consisting of an electrolyte solution, an electrically conductive polymer, and manganese oxide.

10. An electrical circuit comprising the capacitor according to any one of claims 4 to 9.

11. A circuit board comprising the capacitor according to any one of claims 4 to 9.

12. An apparatus comprising the capacitor according to any one of claims 4 to 9.
